# EUROPEAN PATENT APPLICATION

(11) **EP 4 395 342 A1**
(43) Date of publication of application: **03.07.2024**
(21) Application number: 22860426.0
(22) Date of filing: 22.08.2022
(51) Int. Cl.: H04N 23/00

(54) **IMAGE SENSOR, CONTROL METHOD, CONTROL APPARATUS, ELECTRONIC DEVICE AND STORAGE MEDIUM**

(30) Priority: 25.08.2021 CN 202110983304
(71) Applicant: Vivo Mobile Communication Co., Ltd., Dongguan, Guangdong 523863 (CN)
(72) Inventor: LUO, Yi, Dongguan, Guangdong 523863 (CN)
(74) Representative: Lavoix
(86) International application number: PCT/CN2022/113861
(87) International publication number: WO 2023/025080

(57) **Abstract**

This application discloses an image sensor, a control method, a control apparatus, an electronic device, and a storage medium, and pertains to the technical field of electronic devices. The image sensor includes a pixel circuit array, where the pixel circuit array includes a plurality of pixel circuit groups, each pixel circuit group includes one pixel circuit of white pixel and a plurality of pixel circuits of color pixels, and the plurality of pixel circuits of color pixels are disposed around the pixel circuit of white pixel. Each pixel circuit row of the pixel circuit array shares one control signal line, and each pixel circuit column of the pixel circuit array shares one output signal line. The pixel circuit array includes at least two pixel circuit rows and at least two pixel circuit columns, the pixel circuit row includes the pixel circuit of white pixel or the pixel circuit of color pixel, and the pixel circuit column includes the pixel circuit of white pixel or the pixel circuit of color pixel.

## Description

### CROSS-REFERENCE TO RELATED APPLICATIONS

This application claims priority to Chinese Patent Application No. 202110983304.4, filed on August 25, 2021 and entitled "IMAGE SENSOR, CONTROL METHOD, CONTROL APPARATUS, ELECTRONIC DEVICE, AND STORAGE MEDIUM", which is incorporated herein by reference in its entirety.

### TECHNICAL FIELD

This application pertains to the field of electronic devices, and specifically relates to an image sensor, a control method for an image sensor, a control apparatus for an image sensor, an electronic device, and a readable storage medium.

### BACKGROUND

Currently, a five-pixel color filter array (Color Filter Array, CFA) inspired by a light emitting diode (Light Emitting Diode, LED) display technology, that is, RGBW3.0, resolves many disadvantages (for example, decrease in color resolution) in application of a conventional CFA architecture such as RGBW CFA of Kodak and RGB CFA of Bayer. However, a structure of RGBW3.0 is significantly changed compared with the conventional CFA architecture. Currently, there is no corresponding pixel circuit solution, and consequently, precise control cannot be performed on RGBW3.0.

### SUMMARY

An objective of embodiments of this application is to provide an image sensor, a control method for an image sensor, a control apparatus for an image sensor, an electronic device, and a readable storage medium, to resolve a problem that there is no corresponding pixel circuit solution in a related technology and therefore precise control cannot be performed on a color filter array.

According to a first aspect, an embodiment of this application provides an image sensor, and the image sensor includes:
a pixel circuit array, where the pixel circuit array includes a plurality of pixel circuit groups, each pixel circuit group includes one pixel circuit of white pixel and a plurality of pixel circuits of color pixels, and the plurality of pixel circuits of color pixels are disposed around the pixel circuit of white pixel; and
each pixel circuit row of the pixel circuit array shares one control signal line, and each pixel circuit column of the pixel circuit array shares one output signal line; where
the pixel circuit array includes at least two pixel circuit rows and at least two pixel circuit columns, the pixel circuit row includes the pixel circuit of white pixel or the pixel circuit of color pixel, and the pixel circuit column includes the pixel circuit of white pixel or the pixel circuit of color pixel.

According to a second aspect, an embodiment of this application provides an electronic device, and the electronic device includes the image sensor according to the first aspect.

According to a third aspect, an embodiment of this application provides a control method for an image sensor. The image sensor includes a pixel circuit array, the pixel circuit array includes a plurality of pixel circuit groups, each pixel circuit group includes one pixel circuit of white pixel and a plurality of pixel circuits of color pixels, the plurality of pixel circuits of color pixels are disposed around the pixel circuit of white pixel, each pixel circuit row of the pixel circuit array shares one control signal line, and each pixel circuit column of the pixel circuit array shares one output signal line. The control method includes:
in a case that the pixel circuit row includes the pixel circuit of white pixel or the pixel circuit of color pixel and the pixel circuit column includes the pixel circuit of white pixel or the pixel circuit of color pixel, based on a first fusion control signal, fusing an electrical signal generated by the pixel circuit of white pixel and an electrical signal generated by at least one pixel circuit of color pixel, to enhance the electrical signal of the pixel circuit of color pixel.

According to a fourth aspect, an embodiment of this application provides a control apparatus for an image sensor. The image sensor includes a pixel circuit array, the pixel circuit array includes a plurality of pixel circuit groups, each pixel circuit group includes one pixel circuit of white pixel and a plurality of pixel circuits of color pixels, the plurality of pixel circuits of color pixels are disposed around the pixel circuit of white pixel, each pixel circuit row of the pixel circuit array shares one control signal line, and each pixel circuit column of the pixel circuit array shares one output signal line. The control apparatus includes:
a control module, configured to: in a case that the pixel circuit row includes the pixel circuit of white pixel or the pixel circuit of color pixel and the pixel circuit column includes the pixel circuit of white pixel or the pixel circuit of color pixel, based on a first fusion control signal, fuse an electrical signal generated by the pixel circuit of white pixel and an electrical signal generated by at least one pixel circuit of color pixel, to enhance the electrical signal of the pixel circuit of color pixel.

According to a fifth aspect, an embodiment of this application provides an electronic device, the electronic device includes a processor, a memory, and a program or an instruction that is stored in the memory and that can be run on the processor, and when the program or the instruction is executed by the processor, steps of the method according to the third aspect are implemented.

According to a sixth aspect, an embodiment of this application provides a readable storage medium. The readable storage medium stores a program or an instruction, and when the program or the instruction is executed by a processor, steps of the method according to the third aspect are implemented.

According to a seventh aspect, an embodiment of this application provides a chip. The chip includes a processor and a communications interface, the communications interface is coupled to the processor, and the processor is configured to run a program or an instruction to implement the method according to the third aspect.

In the embodiments of this application, a pixel circuit array of an image sensor includes a plurality of pixel circuit groups. Each row of pixel circuits are controlled by a pixel control signal generation module. Each row of pixel circuits of color pixels share one pixel control signal (that is, a control signal line), each row of pixel circuits of white pixel share one pixel control signal (that is, a control signal line), and the pixel control signal shared by each row of pixel circuits of white pixel is independent of the pixel control signal shared by each row of pixel circuits of color pixels. Signals output by each column of pixel circuits share one signal transmission line (that is, an output signal line), and an output signal line of a pixel circuit of color pixel and an output signal line of a pixel circuit of white pixel are independent of each other. The signal transmission line transmits each column of output signals to the pixel output signal processing module, and the pixel output signal processing module processes the output signals.

An embodiment of this application provides a pixel circuit array architecture of RGBW. Compared with a conventional pixel circuit array, the pixel circuit array is rearranged. In one aspect, the pixel circuit array architecture is applicable to a CFA type, so that a problem that a CFA cannot use the conventional pixel circuit array is resolved, and a basis is provided for widespread application of the CFA on a complementary metal-oxide semiconductor image sensor (Complementary Metal-Oxide Semiconductor Image Sensor, CIS). In another aspect, independent processing of a signal between a color pixel and a white pixel is implemented. While adapting to a CFA pixel structure, crosstalk of signals between the color pixel and the white pixel is effectively avoided, and sensitivity of an image sensor is improved.

### BRIEF DESCRIPTION OF DRAWINGS

FIG. 1 is a schematic diagram of arrangement of pixel arrays and arrangement of pixel groups of a complementary metal-oxide semiconductor image sensor according to an embodiment of this application;
FIG. 2 is a first schematic diagram of a structure of a pixel of a complementary metal-oxide semiconductor image sensor according to an embodiment of this application;
FIG. 3 is a second schematic diagram of a structure of a pixel of a complementary metal-oxide semiconductor image sensor according to an embodiment of this application;
FIG. 4 is a schematic diagram of an architecture of a pixel circuit array of a complementary metal-oxide semiconductor image sensor according to an embodiment of this application;
FIG. 5 is a first schematic diagram of a structure of a pixel circuit array according to an embodiment of this application;
FIG. 6 is a first schematic diagram of a structure of a pixel circuit group according to an embodiment of this application;
FIG. 7 is a first schematic diagram of a pixel signal processing circuit according to an embodiment of this application;
FIG. 8 is a second schematic diagram of a pixel signal processing circuit according to an embodiment of this application;
FIG. 9 is a third schematic diagram of a pixel signal processing circuit according to an embodiment of this application;
FIG. 10 is a second schematic diagram of a structure of a pixel circuit array according to an embodiment of this application;
FIG. 11 is a second schematic diagram of a structure of a pixel circuit group according to an embodiment of this application;
FIG. 12 is a schematic flowchart of a control method for an image sensor according to an embodiment of this application;
FIG. 13 is a schematic block diagram of a control apparatus for an image sensor according to an embodiment of this application;
FIG. 14 is a first schematic block diagram of an electronic device according to an embodiment of this application; and
FIG. 15 is a second schematic block diagram of an electronic device according to an embodiment of this application.

### DESCRIPTION OF EMBODIMENTS

The following clearly describes technical solutions in embodiments of this application with reference to accompanying drawings in the embodiments of this application. Apparently, the described embodiments are some but not all of the embodiments of this application. All other embodiments obtained by a person of ordinary skill in the art based on the embodiments of this application shall fall within the protection scope of this application.

The terms "first", "second", and the like in this specification and claims of this application are used to distinguish between similar objects instead of describing a specific order or sequence. It should be understood that the data used in such a way is interchangeable in proper circumstances so that the embodiments of this application can be implemented in an order other than the order illustrated or described herein. In addition, in this specification and the claims, "and/or" represents at least one of connected objects, and a character "/" generally represents an "or" relationship between associated objects.

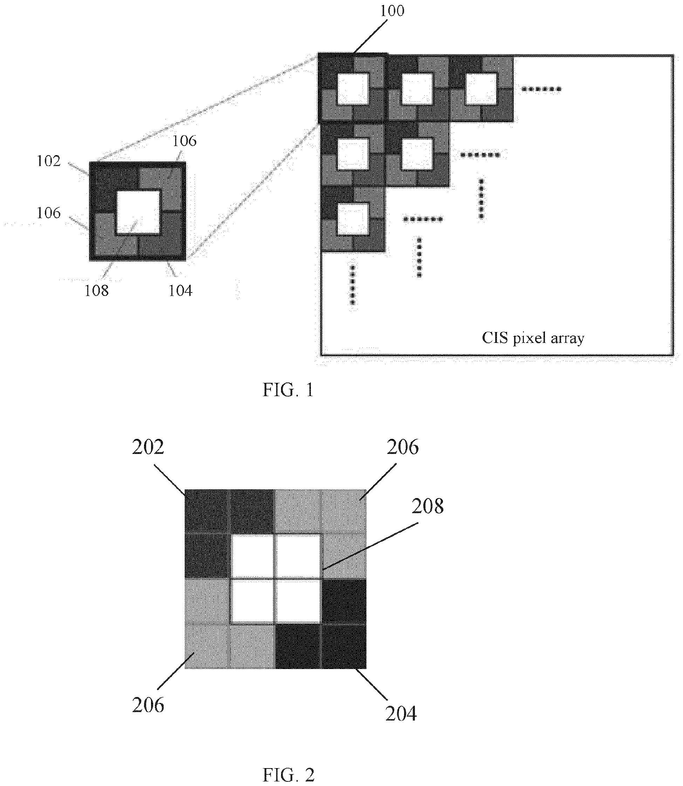

A pixel array (Pixel Array) of a CIS using RGBW3.0 is formed by pixel groups. As shown in FIG. 1, each pixel group 100 has five pixels (Pixel), four of which are colored pixels (that is, color pixels) including a red pixel 102, a blue pixel 104, and two green pixels 106 that are all in an "L" shape, while a transparent white pixel 108 is still square, and the white pixel 108 is located in the exact center of the pixel group 100, and is surrounded by four "L"-shaped color pixels. There is a photosensitive element, such as a photodiode, under a color filter of each color pixel. And the photosensitive element functions to convert light filtered out from the color filter into an electrical signal, such as a current, a voltage, or potential energy, for back-end processing.

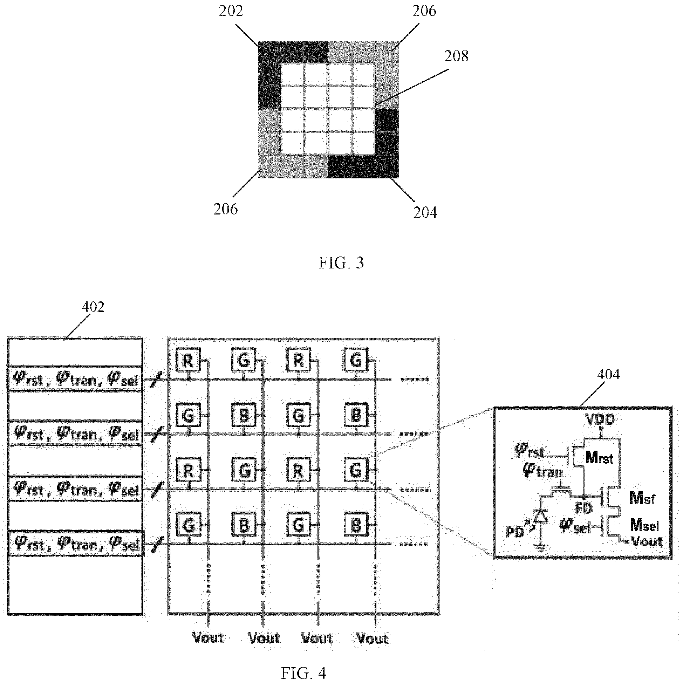

However, in a modem CIS manufacturing process, a special-shaped pixel (that is, an "L" shape) is currently still unable to be used in a large scale in a consumer CIS product due to a problem of a process and a yield rate. For successful practice, an "L"-shaped color pixel in RGBW3.0 is split into a plurality of rectangular pixels. As shown in FIG. 2 and FIG. 3, there are two solutions. As shown in FIG. 2, in a solution 1, a red region 202, a blue region 204, and a green region 206 each consist of three pixels. A white area 208 in the middle includes four pixels, and the pixels have a same size. As shown in FIG. 3, in a solution 2, each color region includes five pixels, and a white region 208 in the center includes 16 pixels. Regardless of the foregoing methods, a ratio of a quantity of green pixels, a quantity of red pixels, and a quantity of blue pixels remains unchanged and is always 2: 1:1. However, due to a change in the quantity of white pixels, a ratio of white pixels to color pixels in the method 1 is 1: 3, and a ratio of white pixels to color pixels in the method 2 is 4:5.

A pixel circuit array architecture of a CIS using RGBW3.0 is shown in FIG. 4. Each row of pixels share one group of pixel control signals, and the pixel control signal includes a pixel reset signal (*ϕ*ᵣₛₜ) used to control reset time of a pixel, a charge transfer switching signal (*ϕ*ₜᵣₐₙ) used to control exposure time of a pixel, and a pixel signal read switching signal (*ϕ*ₛₑₗ) used to control reading time of a pixel. The pixel control signal is generated by a pixel control signal generation module 402. Each column of pixels share one pixel output signal (Vₒᵤₜ) transmission line. Each row of pixels use the shared transmission line in turn to transmit Vₒᵤₜ to a back-end signal processing circuit.

Each pixel includes a pixel circuit. As shown in FIG. 4, a pixel circuit 404 includes four transistor active pixel sensor (Active Pixel Sensor, APS) circuits. A light-sensitive photodiode (Photodiode, PD) converts light into electrons and then transfers the electrons to a floating diffusion (Floating Diffusion, FD) region through a charge transfer transistor (on/off of which is controlled by *ϕ*ₜᵣₐₙ). When a pixel is selected and read (a level of *ϕ*ₛₑₗ is pulled up), a quantity of charges in FD is read as a voltage signal by a source follower (Source Follower) including M_{sf} and Mₛₑₗ and output as Vₒᵤₜ.

After an RGBW3.0 CFA is used, a structure of the RGBW3.0 CFA is significantly changed compared with a conventional CFA form such as RGB of Bayer and RGBW of Kodak, and therefore, a conventional pixel circuit array cannot be applicable. An image sensor and an electronic device provided in this application can resolve the foregoing problem.

An image sensor, a control method for an image sensor, a control apparatus for an image sensor, an electronic device, and a readable storage medium provided in embodiments of this application are described below in detail with reference to the accompanying drawings by using specific embodiments and application scenarios thereof.

An embodiment of this application provides an image sensor, and the image sensor includes:
a pixel circuit array, where the pixel circuit array includes a plurality of pixel circuit groups, each pixel circuit group includes one pixel circuit of white pixel and a plurality of pixel circuits of color pixels, and the plurality of pixel circuits of color pixels are disposed around the pixel circuit of white pixel; where
each pixel circuit row of the pixel circuit array shares one control signal line, and each pixel circuit column of the pixel circuit array shares one output signal line; and
the pixel circuit array includes at least two pixel circuit rows and at least two pixel circuit columns, the pixel circuit row includes the pixel circuit of white pixel or the pixel circuit of color pixel, and the pixel circuit column includes the pixel circuit of white pixel or the pixel circuit of color pixel.

In this embodiment, for a solution of an "L"-shaped pixel structure, a CFA of a pixel layer uses the layout shown in FIG. 1, and each pixel group includes four color pixels and one white pixel. The four color pixels include a red pixel (R), a blue pixel (B), and two green pixels (G), all of which are in an "L" shape, while a transparent white pixel (W) is a square, and the white pixel is located in the exact center of a pixel group, and is surrounded by four "L"-shaped color pixels.

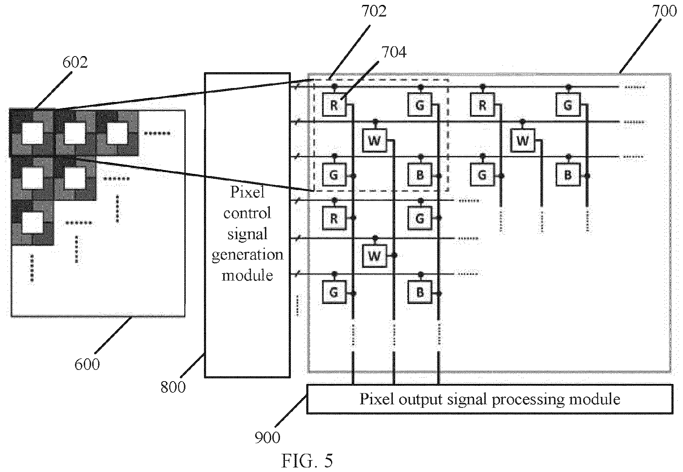

Circuit structures of a pixel array 600 and a pixel circuit array 700 corresponding to the pixel array 600 are shown in FIG. 5. The pixel circuit array 700 includes a plurality of pixel circuit groups 702, one pixel circuit group 702 includes a plurality of pixel circuits 704 (one pixel group 602 in the pixel array 600 corresponds to one pixel circuit group 702, and one pixel in the pixel array 600 corresponds to one pixel circuit 704), and each row of pixel circuits are controlled by a pixel control signal generation module 800.

The pixel circuit row includes the pixel circuit of white pixel or the pixel circuit of color pixel, and the pixel circuit column includes the pixel circuit of white pixel or the pixel circuit of color pixel. This is equivalent to that each row of pixel circuits of color pixels share one pixel control signal (that is, a control signal line), each row of pixel circuits of white pixel share one pixel control signal (that is, a control signal line), and the pixel control signal shared by each row of pixel circuits of white pixel is independent of the pixel control signal shared by each row of pixel circuits of color pixels. Signals output by each column of pixel circuits share one signal transmission line (that is, an output signal line), and an output signal line of the pixel circuit of color pixel and an output signal line of the pixel circuit of white pixel are independent of each other. The signal transmission line transmits each column of output signals (Vout) to a pixel output signal processing module 900, and the pixel output signal processing module 900 performs processing.

An embodiment of this application provides a pixel circuit array architecture of RGBW. Compared with a conventional pixel circuit array, the pixel circuit array is rearranged. In one aspect, the pixel circuit array architecture is applicable to a CFA type (for example, an RGBW3.0 CFA), so that a problem that a CFA cannot use the conventional pixel circuit array is resolved, and a basis is provided for widespread application of the CFA on a CIS. In another aspect, independent processing of a signal between a color pixel and a white pixel is implemented. While adapting to a CFA pixel structure, crosstalk of signals between the color pixel and the white pixel is effectively avoided, and sensitivity of an image sensor is improved.

Further, in an embodiment of this application, in each pixel circuit group, an electrical signal generated by the pixel circuit of white pixel and an electrical signal generated by at least one pixel circuit of color pixel may be fused based on a first fusion control signal.

In this embodiment, signal fusion (Bining) processing may be performed on an electrical signal of the pixel circuit of white pixel and electrical signals of one or more pixel circuits of color pixels. In the foregoing manner, image fusion can be completed in a pixel group, so that chromatic aberration caused by signal attenuation when a back-end ISP performs a fusion algorithm is avoided, and power consumption is reduced.

Further, in an embodiment of this application, the pixel circuit includes: a first photosensitive element, a first switching element connected to the first photosensitive element, and a first signal processing circuit connected to the first switching element and the output signal line. The pixel circuit includes the pixel circuit of color pixel or the pixel circuit of white pixel.

The first photosensitive element is configured to generate an electrical signal in a case that light is sensed. The first switching element is configured to be turned on or off based on a first charge transfer control signal. The first signal processing circuit is configured to receive and process an electrical signal generated by the first photosensitive element in a case that the first switching element is turned on. For example, the first signal processing circuit may reset a signal, that is, set the electrical signal generated by the first photosensitive element to an initial voltage, or the first signal processing circuit reads a signal, that is, transmits the electrical signal generated by the first photosensitive element to a pixel output signal processing module through the output signal line.

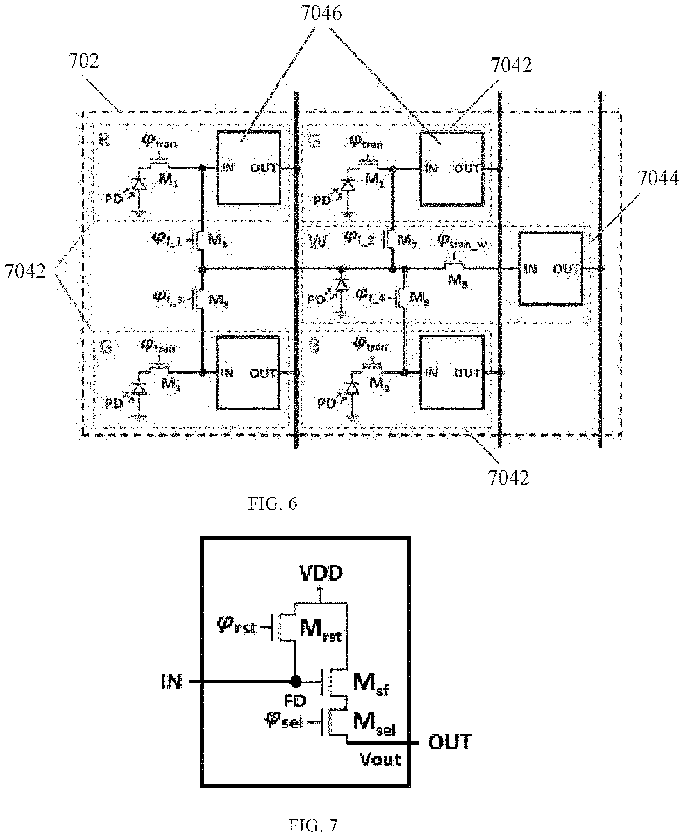

In this embodiment, a pixel circuit group of each pixel group is shown in FIG. 6. Each pixel in the pixel group has an independent pixel circuit, and one pixel circuit group 702 includes four pixel circuits of color pixels 7042and one pixel circuit of white pixel 7044. Each pixel circuit (the pixel circuit of color pixel 7042 or the pixel circuit of white pixel 7044) includes one first photosensitive element (that is, PD), one first switching element (that is, a charge transfer switch transistor including M₁, M₂, M₃, M₄, or M₅), and one first signal processing circuit 7046. A photosensitive element in each pixel circuit generates an electrical signal after sensing light, and the electrical signal is read by the first signal processing circuit 7046 after passing through the first switching element controlled by a first charge transfer control signal (that is, a *ϕ*ₜᵣₐₙ signal or a *ϕ*_{tran_w} signal). After processing the electrical signal, the first signal processing circuit 7046 transmits the electrical signal to a pixel output signal processing module through the output signal line.

The pixel circuit architecture in this embodiment of this application is applicable to an "L"-shaped pixel of a CFA type (for example, an RGBW3.0 CFA), so that a problem that a CFA cannot use a conventional pixel circuit array is resolved, and application of the CFA is facilitated.

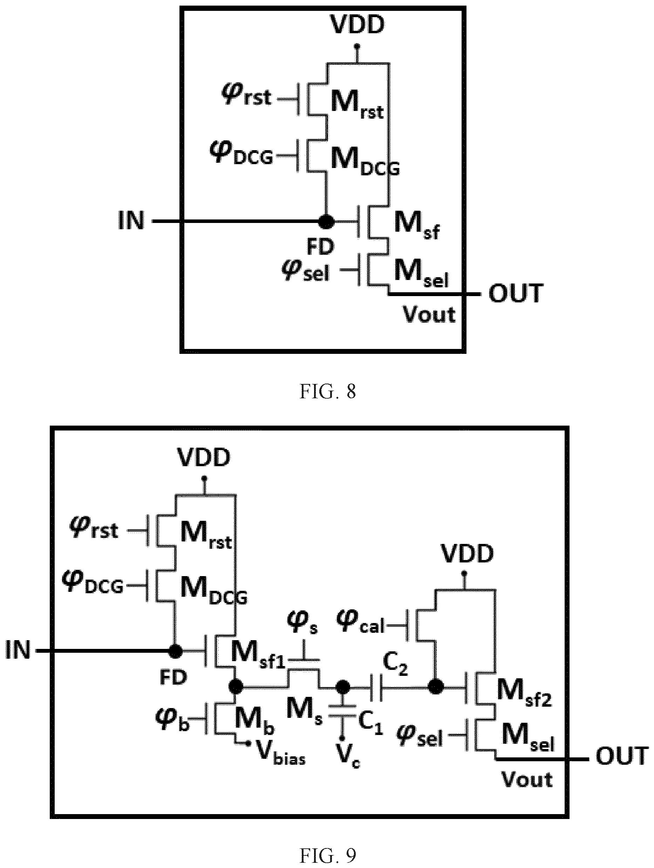

It should be noted that, a main function of the first signal processing circuit (that is, a pixel signal processing circuit) in the pixel circuit is to reset a pixel and generate a pixel output signal. FIG. 7 to FIG. 9 show several typical pixel signal processing circuits (where IN is an input and OUT is an output). Specifically, FIG. 7 shows an APS-type pixel signal processing circuit. FIG. 8 shows an APS-type pixel signal processing circuit with a DCG function. FIG. 9 shows a global shutter APS-type pixel signal processing circuit with a dual conversion gain (Dual Conversion Gain, DCG) function. Because there are a plurality of solutions for the pixel signal processing circuit, a hybrid method may be used. For example, a color pixel uses an APS type with a DCG function, and a white pixel uses a global shutter APS type with a DCG function.

Further, in an embodiment of this application, the pixel circuit group further includes a plurality of second switching elements, and the second switching element is connected between the pixel circuit of white pixel and the pixel circuit of color pixel.

The second switching element is configured to be turned on or off based on a first fusion control signal. In a case that the second switching element is turned on, an electrical signal generated by the pixel circuit of white pixel is fused in an electrical signal generated by a pixel circuit of color pixel connected to the second switching element.

In this embodiment, the pixel circuit group further includes a plurality of second switching elements, and one second switching element is connected between one pixel circuit of white pixel and one pixel circuit of color pixel. As shown in FIG. 6, for a pixel circuit group 702, four second switching elements (that is, signal fusion switching transistors M₆, M₇, M₈, and M₉) are all in a disconnected state in a case that pixel fusion is not required. If pixel fusion is required, one or more of the signal fusion switching transistors M₆, M₇, M₈, and M₉ are closed and connected when being driven by a fist fusion control signal (that is, one or more of signals *ϕ*_{f_1}, *ϕ*_{f_2}, *ϕ*_{f_3}, and *ϕ*_{f_4}). In this case, the electrical signal generated by the white pixel is fused into one or more color pixels, to complete a fusion operation of the white pixel signal. For example, when the white pixel needs to be fused with a red pixel (R) and a blue pixel (B) in the color pixels, M₆ and M₉ are respectively closed when being driven by the signal *ϕ*_{f_1} and the signal *ϕ*_{f_4}, so that the white pixel is fused with the red pixel (R) and the blue pixel (B).

In the foregoing manner, image fusion of the white pixel and at least one color pixel can be completed in the pixel group according to an actual requirement, so that chromatic aberration caused by signal attenuation when a back-end ISP performs a fusion algorithm is avoided, and power consumption is reduced.

Further, in an embodiment of this application, in a case that the pixel circuit of white pixel includes a plurality of pixel circuits of white sub-pixels, and the pixel circuit of color pixel includes a plurality of pixel circuits of color sub-pixels, the pixel circuit row includes the pixel circuit of color sub-pixel or includes the pixel circuit of white sub-pixel and the pixel circuit of color sub-pixel, and the pixel circuit column includes the pixel circuit of color sub-pixel or includes the pixel circuit of white sub-pixel and the pixel circuit of color sub-pixel.

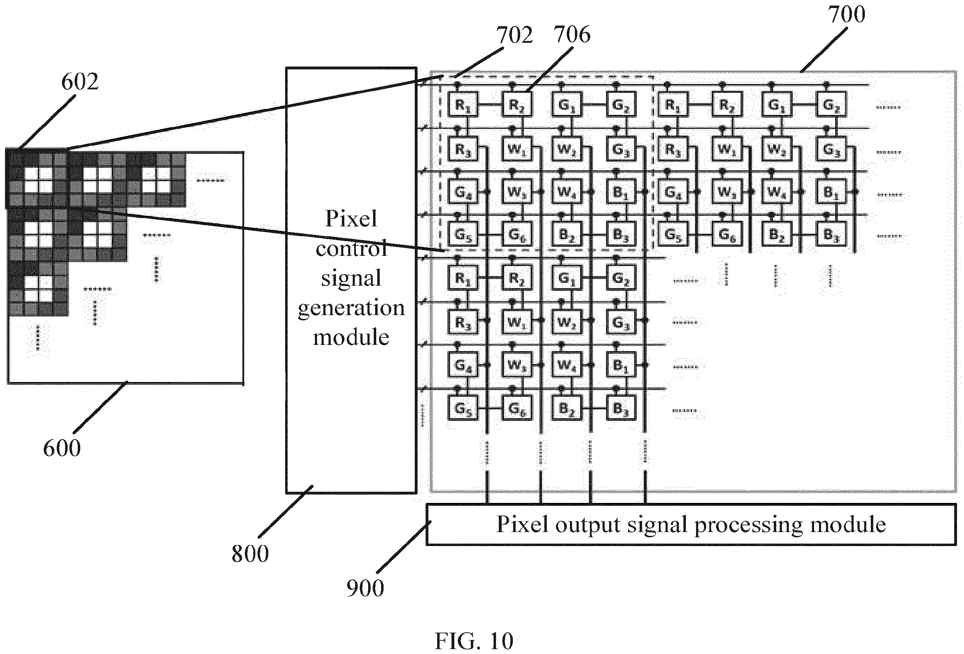

In this embodiment, for a composite pixel solution (as shown in FIG. 2 and FIG. 3) for splitting the white pixel into a plurality of rectangular white sub-pixels and splitting the color pixel into a plurality of rectangular color sub-pixels, a structure shown in FIG. 2 is used as an example. Each pixel group 602 of the pixel array 600 includes 16 sub-pixels. Therefore, as shown in FIG. 10, each pixel circuit group 702 of the pixel circuit array 700 includes 16 pixel circuits of sub-pixels 706 that are specifically four pixel circuits of white sub-pixels and 12 pixel circuits of color sub-pixels. Each row of pixel circuits of sub-pixels are controlled by a pixel control signal generation module 800, and output signals of each column of pixel circuits of sub-pixels are transmitted to the pixel output signal processing module 900, and are processed by the pixel output signal processing module 900.

In the pixel circuit array, each row of pixel circuits of sub-pixels include two cases: One is that each row includes only the pixel circuit of color sub-pixel, and the other is that each row includes the pixel circuit of white sub-pixel and the pixel circuit of color sub-pixel; and each column of pixel circuits of sub-pixels include two cases: One is that each column includes only the pixel circuit of color sub-pixel, and the other is that each column includes the pixel circuit of white sub-pixel and the pixel circuit of color sub-pixel.

All pixel circuits of sub-pixels (regardless of the pixel circuit of color sub-pixel or the pixel circuit of white sub-pixel) in each row are controlled by a pixel control signal generation module, that is, all pixel circuits of sub-pixels in each row share one pixel control signal (that is, the control signal line). Signals output by all pixel circuits of sub-pixels (regardless of the pixel circuit of color sub-pixel or the pixel circuit of white sub-pixel) in each column share one signal transmission line (that is, the output signal line) to a pixel output signal processing module.

An embodiment of this application provides a pixel circuit array architecture of RGBW. In one aspect, the pixel circuit array architecture is applicable to a composite pixel solution of a CFA type (for example, an RGBW3.0 CFA), and resolves a problem that a conventional pixel circuit array cannot be used in the composite pixel solution of a CFA, and provides a basis for widespread application of the CFA on a CIS. In another aspect, signal processing and reading may be performed on each pixel circuit in the pixel circuit array, so that while a CFA pixel structure is applicable, crosstalk between pixels is effectively avoided.

Further, in an embodiment of this application, in each pixel circuit group, based on a second fusion control signal, an electrical signal generated by the pixel circuit of white sub-pixel is fused with an electrical signal generated by at least one pixel circuit of color sub-pixel.

In this embodiment, signal fusion processing may be performed on the electrical signal of the pixel circuit of white sub-pixel and electrical signals of one or more pixel circuits of color sub-pixels. In the foregoing manner, image fusion can be completed in the pixel group, so that chromatic aberration caused by signal attenuation when a back-end ISP performs a fusion algorithm is avoided, and power consumption is reduced.

Further, in an embodiment of this application, the pixel circuit group further includes a second signal processing circuit connected to the output signal line, and the pixel circuit includes a second photosensitive element and a third switching element connected to the second photosensitive element and the second signal processing circuit. The pixel circuit includes the pixel circuit of color pixel or the pixel circuit of white pixel.

The second photosensitive element is configured to generate an electrical signal in a case that light is sensed, and the third switching element is configured to be turned on or off based on a charge transfer control signal. In a case that the third switching element is turned on, the electrical signal generated by the second photosensitive element is transmitted to a second signal processing circuit for processing, for example, performing signal reset or signal reading.

In this embodiment, each sub-pixel in the pixel group has an independent pixel circuit of sub-pixel. The pixel circuit of color sub-pixel or the pixel circuit of white sub-pixel includes a second photosensitive element and a third switching element. The second photosensitive element generates an electrical signal in a case that light is sensed, and in a case that the third switching element is turned on, the electrical signal is transmitted to the second signal processing circuit of the pixel circuit group for processing.

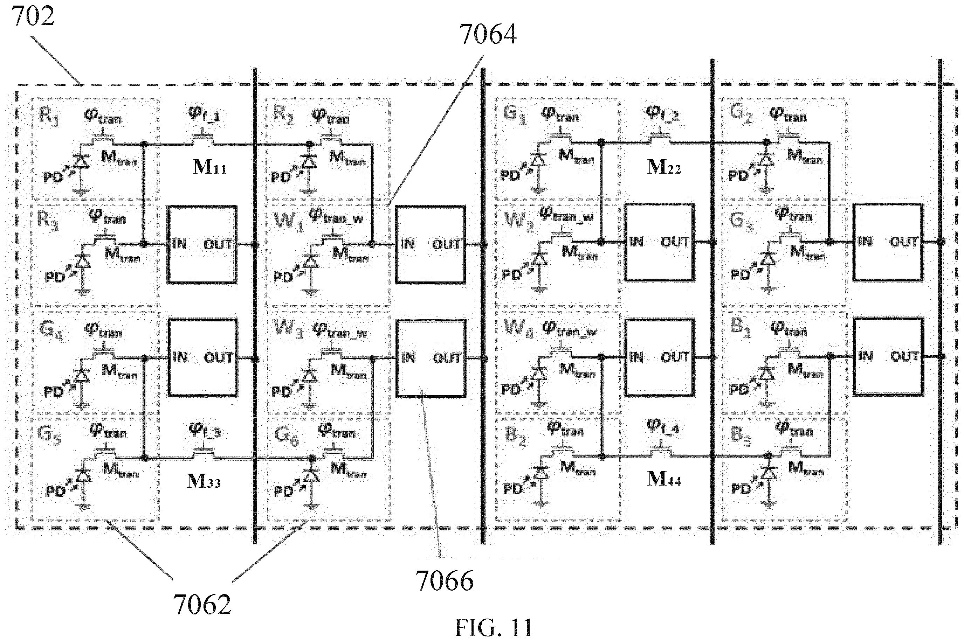

For example, a pixel circuit group of each pixel group may be shown in FIG. 11. Each sub-pixel in the pixel group has an independent sub-pixel, and one pixel circuit group 702 includes 12 pixel circuits of color sub-pixels 7062 and four pixel circuits of white sub-pixels 7064.

Each pixel circuit of sub-pixel (the pixel circuit of color sub-pixel 7062 or the pixel circuit of white sub-pixel 7064) includes one second photosensitive element (that is, PD) and one third switching element (that is, a charge transfer switching transistor M_{Tran}). A photosensitive element in each pixel circuit of sub-pixel generates an electrical signal after sensing light, and the electrical signal is read by a second signal processing circuit 7066 after passing through a third switching element controlled by a charge transfer control signal (that is, a *ϕ*ₜᵣₐₙ signal or a *ϕ*_{tran_w} signal). After the electrical signal is processed by the second signal processing circuit 7066, the electrical signal is transmitted to a pixel output signal processing module through the output signal line.

The pixel circuit of sub-pixel architecture in this embodiment of this application is applicable to sub-pixels split from an "L"-shaped pixel of a CFA type (for example, an RGBW3.0 CFA), so that a problem that a CFA cannot use a conventional pixel circuit array is resolved, and application of the CFA is facilitated.

It should be noted that, a main function of the second signal processing circuit (that is, a pixel signal processing circuit) of the pixel circuit group is to reset a pixel and generate a pixel output signal. FIG. 7 to FIG. 9 show several typical pixel signal processing circuits. The pixel signal processing circuit processes the electrical signal and then outputs the electrical signal to the output signal line, and performs a next signal processing step after the electrical signal reaches the pixel output signal processing module.

Further, in an embodiment of this application, two adjacent pixel circuits of sub-pixels in each column of pixel circuits of sub-pixels of the pixel circuit array share one second signal processing circuit. The second signal processing circuit is connected to two adjacent third switching elements.

The second signal processing circuit is configured to: in a case that the third switching element is turned on, receive and process an electrical signal generated by the second photosensitive element, and transmit the processed electrical signal to the output signal line.

In this embodiment, as shown in FIG. 11, in each column, every two pixel circuits of sub-pixels share one second signal processing circuit 7066 (that is, a pixel signal processing circuit). For example, a pixel circuit of color sub-pixel R1 and a pixel circuit of color sub-pixel R3 share one pixel signal processing circuit, a pixel circuit of color sub-pixel R2, and a pixel circuit of white sub-pixel W1 share one pixel signal processing circuit, and a pixel circuit of color sub-pixel G1 and a pixel circuit of white sub-pixel W2 share one pixel signal processing circuit.

In the foregoing manner, a quantity of signal processing circuits is reduced, and while pixel circuits can still be read row by row, occupation space is reduced, costs are reduced, and power consumption is reduced.

In addition, as shown in FIG. 11, if M11 is turned on, the pixel circuit of color sub-pixel R1 and the pixel circuit of color sub-pixel R3 can share one pixel signal processing circuit, and the pixel circuit of color sub-pixel R2 and the pixel circuit of white sub-pixel W1 can share one pixel signal processing circuit.

Further, in an embodiment of this application, the pixel circuit group further includes a plurality of fourth switching elements, the fourth switching element is connected between two adjacent pixel circuit teams in different pixel circuit columns, and the pixel circuit team includes two pixel circuits of sub-pixels that share one second signal processing circuit.

The fourth switching element is configured to be turned on or off based on a fusion control signal, and in a case that the third switching element and the fourth switching element are turned on, electrical signals generated by two pixel circuits corresponding to the third switching element and the fourth switching element are fused.

In this embodiment, the fourth switching element, that is, a fusion switching transistor, is disposed between two adjacent pixel circuit teams in different pixel circuit columns. When the third switching element and the fourth switching element are turned on, signal fusion is implemented between pixel circuits of sub-pixels corresponding to the third switching element and the fourth switching element.

For example, as shown in FIG. 11, among different columns of the pixel circuit group, four fusion switching transistors (M₁₁, M₂₂, M₃₃, and M₄₄) are closed and connected when being driven by one or more second fusion control signals (that is, one or more of *ϕ*_{f_1}, *ϕ*_{f_2}, *ϕ*_{f_3}, and *ϕ*_{f_4} signals). If pixel fusion is required, at most four pixel circuits of sub-pixels (for example, R₁, R₂, R₃, and W₁) are fused by using different combinations of *ϕ*ₜᵣₐₙ or *ϕ*_{tran_w} and the *ϕ*_{f_1}, *ϕ*_{f_2}, *ϕ*_{f_3}, and *ϕ*_{f_4} signals, and are read by the second signal processing circuit 7066, to complete an operation of fusing color sub-pixel signals and an operation fusing the white sub-pixel signal and color sub-pixel signal. If pixel fusion is not required, all the four fusion switching transistors (M₁₁, M₂₂, M₃₃, and M₄₄) are disconnected, that is, the *ϕ*_{f_1}, *ϕ*_{f_2}, *ϕ*_{f_3}, and *ϕ*_{f_4} signals are pulled down, each second signal processing circuit 7066 is connected to only one pixel circuit of sub-pixel (that is, one *ϕ*ₜᵣₐₙ is pulled up) for signal reading.

For example, *ϕ*ₜᵣₐₙ or *ϕ*_{tran_w} corresponding to the pixel circuit of color sub-pixel R₁, the pixel circuit of color sub-pixel R₂, the pixel circuit of color sub-pixel R₃, and the pixel circuit of white sub-pixel W₁ is pulled up, so that charge transfer switching transistors Mₜᵣₐₙ corresponding to the pixel circuit of color sub-pixel R₁, the pixel circuit of color sub-pixel R₂, the pixel circuit of color sub-pixel R₃, and the pixel circuit of white sub-pixel W₁ are turned on, a fusion switching transistor M₁₁ between a pixel circuit team of the pixel circuit of color sub-pixel R₁ and the pixel circuit of color sub-pixel R₂ and a pixel circuit group of the pixel circuit of color sub-pixel R₃ and the pixel circuit of white sub-pixel W₁ is turned on (that is, *ϕ*_{f_1} is pulled up), and finally, signal fusion between the pixel circuit of color sub-pixel R₁, the pixel circuit of color sub-pixel R₂, the pixel circuit of color sub-pixel R₃, and the pixel circuit of white sub-pixel W₁ is implemented.

In this embodiment of this application, signal fusion processing may be performed on signals of pixel circuits of color sub-pixels, and an algorithm such as a high dynamic range is implemented in the pixel group. Signal fusion processing may be performed on the pixel circuit of white sub-pixel and the pixel circuit of color sub-pixel, so that image fusion can be completed in the pixel group, thereby avoiding chromatic aberration caused by signal attenuation when a back-end ISP performs a fusion algorithm, and reducing power consumption.

It should be noted that, because pixel array arrangement shown in FIG. 3 is not substantially different from pixel array arrangement shown in FIG. 2, a pixel circuit array of the pixel array arrangement shown in FIG. 3 can also be implemented in the foregoing manner.

An embodiment of this application provides an electronic device, and the electronic device includes the image sensor in the foregoing embodiments.

In this embodiment, the pixel circuit array of the image sensor includes a plurality of pixel circuit groups. Each row of pixel circuits are controlled by a pixel control signal generation module. Each row of pixel circuits of color pixels share one pixel control signal (that is, a control signal line), each row of pixel circuit of white pixels share one pixel control signal (that is, a control signal line), and the pixel control signal shared by each row of pixel circuits of white pixel is independent of the pixel control signal shared by each row of pixel circuits of color pixels. Signals output by each column of pixel circuits share one signal transmission line (that is, an output signal line), and an output signal line of the pixel circuit of color pixel and an output signal line of the pixel circuit of white pixel are independent of each other. The signal transmission line transmits each column of output signals to a pixel output signal processing module, and the pixel output signal processing module performs processing.

An embodiment of this application provides a pixel circuit array architecture of RGBW. Compared with a conventional pixel circuit array, the pixel circuit array is rearranged. In one aspect, the pixel circuit array architecture is applicable to a CFA type (for example, an RGBW3.0 CFA), so that a problem that a CFA cannot use the conventional pixel circuit array is resolved, and a basis is provided for widespread application of the CFA on a CIS. In another aspect, independent processing of a signal between a color pixel and a white pixel in the pixel circuit array is implemented. While adapting to a CFA pixel structure, crosstalk of signals between the color pixel and the white pixel is effectively avoided, and sensitivity of an image sensor is improved.

The electronic device may be a mobile electronic device, or may be a non-mobile electronic device. For example, the mobile electronic device may be a mobile phone, a tablet computer, a notebook computer, a palmtop computer, an in-vehicle terminal device, a wearable device, an ultra-mobile personal computer (Ultra-Mobile Personal Computer, UMPC), a netbook, or a personal digital assistant (Personal Digital Assistant, PDA), and the non-mobile electronic device may be a server, a network attached storage (Network Attached Storage, NAS), a personal computer (Personal Computer, PC), a television (Television, TV), a teller machine, or a self-service machine. This is not specifically limited in this embodiment of this application.

The electronic device in this embodiment of this application may be an apparatus with an operating system. The operating system may be an Android (Android) operating system, may be an iOS operating system, or may be another possible operating system. This is not specifically limited in this embodiment of this application.

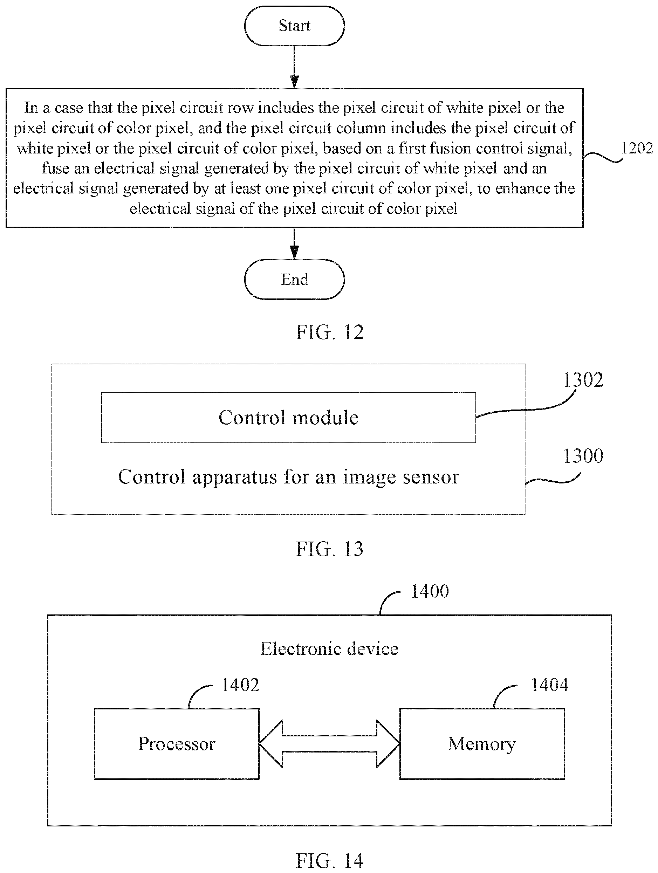

An embodiment of this application provides a control method for an image sensor. The image sensor includes a pixel circuit array, the pixel circuit array includes a plurality of pixel circuit groups, each pixel circuit group includes one pixel circuit of white pixel and a plurality of pixel circuits of color pixels, the plurality of pixel circuits of color pixels are disposed around the pixel circuit of white pixel, each pixel circuit row of the pixel circuit array shares one control signal line, and each pixel circuit column of the pixel circuit array shares one output signal line. As shown in FIG. 12, the method includes the following steps.

Step 1202: In a case that the pixel circuit row includes the pixel circuit of white pixel or the pixel circuit of color pixel, and the pixel circuit column includes the pixel circuit of white pixel or the pixel circuit of color pixel, based on a first fusion control signal, fuse an electrical signal generated by the pixel circuit of white pixel and an electrical signal generated by at least one pixel circuit of color pixel, to enhance the electrical signal of the pixel circuit of color pixel.

In this embodiment, signal fusion processing may be performed on the electrical signal of the pixel circuit of white pixel and electrical signals of one or more pixel circuits of color pixels. In the foregoing manner, image fusion can be completed in a pixel group, thereby avoiding chromatic aberration caused by signal attenuation when a back-end ISP performs a fusion algorithm, and reducing power consumption.

Further, in an embodiment of this application, the pixel circuit of color pixel or the pixel circuit of white pixel includes a first photosensitive element, a first switching element, and a first signal processing circuit. The control method includes: controlling, based on a first charge transfer control signal, to turn on the first switching element; transmitting, to the first signal processing circuit, an electrical signal generated by the first photosensitive element; and controlling the first signal processing circuit to perform first preset processing on the electrical signal generated by the first photosensitive element, where the first preset processing includes: setting the electrical signal generated by the first photosensitive element to an initial voltage, or outputting the electrical signal generated by the first photosensitive element to the output signal line.

In this embodiment, as shown in FIG. 6, one pixel circuit group 702 includes four pixel circuits of color pixels 7042 and one pixel circuit of white pixel 7044. One pixel circuit (the pixel circuit of color pixel 7042 or the pixel circuit of white pixel 7044) includes one first photosensitive element (that is, PD), one first switching element (that is, a charge transfer switch transistor including M₁, M₂, M₃, M₄, or M₅), and one first signal processing circuit 7046. A photosensitive element in each pixel circuit generates an electrical signal after sensing light, and after the electrical signal passes through the first switching element controlled by a first charge transfer control signal (that is, a *ϕ*ₜᵣₐₙ signal or a *ϕ*_{tran_w} signal), the first signal processing circuit 7046 performs signal resetting processing, that is, the electrical signal generated by the first photosensitive element is set to an initial voltage, or the first signal processing circuit 7046 performs signal reading processing, that is, the electrical signal generated by the first photosensitive element is transmitted to a pixel output signal processing module through the output signal line.

This embodiment of this application is applicable to an "L"-shaped pixel of a CFA type (for example, an RGBW3.0 CFA), so that a problem that a CFA cannot use a conventional pixel circuit array is resolved, and application of the CFA is facilitated.

Further, in an embodiment of this application, the pixel circuit group includes a plurality of second switching elements, and the second switching element is connected between the pixel circuit of white pixel and the pixel circuit of color pixel. The control method includes: controlling, based on a first fusion control signal, to turn on the second switching element, and performing signal fusion on an electrical signal generated by the pixel circuit of white pixel and an electrical signal generated by the pixel circuit of color pixel, to enhance the electrical signal of the pixel circuit of color pixel.

In this embodiment, the pixel circuit group further includes a plurality of second switching elements, and one second switching element is connected between one pixel circuit of white pixel and one pixel circuit of color pixel. As shown in FIG. 6, for a pixel circuit group 702, in a case that pixel fusion is not required, four second switching elements (that is, signal fusion switching transistors M₆, M₇, M₈, and M₉) are all in a disconnected state. If pixel fusion is required, one or more of the signal fusion switching transistors M₆, M₇, M₈, and M₉ are closed and connected when being driven by the first fusion control signal (that is, one or more of *ϕ*_{f_1}, *ϕ*_{f_2}, *ϕ*_{f_3}, and *ϕ*_{f_4} signals), and in this case, the electrical signal generated by the white pixels is fused into one or more color pixels, to complete an operation of fusing a white pixel signal.

In the foregoing manner, image fusion of the white pixel and at least one color pixel can be completed in the pixel group according to an actual requirement, so that chromatic aberration caused by signal attenuation when a back-end ISP performs a fusion algorithm is avoided, and power consumption is reduced.

Further, in an embodiment of this application, in a case that the pixel circuit of white pixel includes a plurality of pixel circuits of white sub-pixels and the pixel circuit of color pixel includes a plurality of pixel circuits of color sub-pixels, the pixel circuit row includes the pixel circuit of color sub-pixel or includes the pixel circuit of white sub-pixel and the pixel circuit of color sub-pixel, and the pixel circuit column includes the pixel circuit of color sub-pixel or includes the pixel circuit of white sub-pixel and the pixel circuit of color sub-pixel. The control method further includes: in each pixel circuit group, controlling, based on a second fusion control signal, to fuse an electrical signal generated by the pixel circuit of white sub-pixel and an electrical signal generated by at least one pixel circuit of color sub-pixel, to enhance the electrical signal of the pixel circuit of color sub-pixel.

In this embodiment, in a case that the pixel circuit of white pixel includes a plurality of pixel circuits of white sub-pixels and the pixel circuit of color pixel includes a plurality of pixel circuits of color sub-pixels, in the pixel circuit array, each row of pixel circuits of sub-pixels include two cases: One is that each row includes only the pixel circuit of color sub-pixel, and the other is that each row includes the pixel circuit of white sub-pixel and the pixel circuit of color sub-pixel; and each column of pixel circuits of sub-pixels include two cases: One is that each column includes only the pixel circuit of color sub-pixel, and the other is that each column includes the pixel circuit of white sub-pixel and the pixel circuit of color sub-pixel.

The electrical signal of the pixel circuit of white sub-pixel and electrical signals of one or more pixel circuits of color sub-pixels can be fused. In the foregoing manner, image fusion can be completed in the pixel group, thereby avoiding chromatic aberration caused by signal attenuation when a back-end ISP performs a fusion algorithm, and reducing power consumption.

Further, in an embodiment of this application, the pixel circuit group includes a second signal processing circuit, and the pixel circuit of color sub-pixel or the pixel circuit of white sub-pixel includes a second photosensitive element and a third switching element. The control method includes: controlling, based on a second charge transfer control signal, to turn on the third switching element; transmitting an electrical signal generated by the second photosensitive element to the second signal processing circuit; and controlling the second signal processing circuit to perform second preset processing on the electrical signal generated by the second photosensitive element, where the second preset processing includes: setting the electrical signal generated by the second photosensitive element to an initial voltage, or outputting the electrical signal generated by the second photosensitive element to the output signal line.

In this embodiment, each sub-pixel in the pixel group has an independent pixel circuit of sub-pixel. The pixel circuit of color sub-pixel or the pixel circuit of white sub-pixel includes a second photosensitive element and a third switching element. The second photosensitive element generates an electrical signal in a case that light is sensed. In a case that the third switching element is turned on, the electrical signal is transmitted to the second signal processing circuit of the pixel circuit group for processing, for example, resetting the signal or reading the signal.

This embodiment of this application is applicable to sub-pixels split from an "L"-shaped pixel of a CFA type (for example, an RGBW3.0 CFA), so that a problem that a CFA cannot use a conventional pixel circuit array is resolved, and application of the CFA is facilitated.

Further, in an embodiment of this application, the pixel circuit group further includes a plurality of fourth switching elements, the fourth switching element is connected between two adjacent pixel circuit teams in different pixel circuit columns, and the pixel circuit team includes two pixel circuits of sub-pixels that share one second signal processing circuit. The control method further includes: controlling, based on a second charge transfer control signal, to turn on the third switching element; controlling, based on a second fusion control signal, to turn on the fourth switching element; and fusing electrical signals generated by two pixel circuit teams corresponding to the third switching element and the fourth switching element, to enhance the electrical signals generated by the pixel circuit teams.

In this embodiment, the fourth switching element, that is, a fusion switching transistor, is disposed between two adjacent pixel circuit teams in different pixel circuit columns. When the third switching element and the fourth switching element are turned on, signal fusion is implemented between pixel circuits of sub-pixels corresponding to the third switching element and the fourth switching element.

For example, as shown in FIG. 11, *ϕ*ₜᵣₐₙ or *ϕ*_{tran_w} corresponding to the pixel circuit of color sub-pixel R₁, the pixel circuit of color sub-pixel R₂, the pixel circuit of color sub-pixel R₃, and the pixel circuit of white sub-pixel W₁ is pulled up, so that charge transfer switching transistors Mₜᵣₐₙ corresponding to the pixel circuit of color sub-pixel R₁, the pixel circuit of color sub-pixel R₂, the pixel circuit of color sub-pixel R₃, and the pixel circuit of white sub-pixel W₁ are turned on, a fusion switching transistor M₁₁ between a pixel circuit team of the pixel circuit of color sub-pixel R₁ and the pixel circuit of color sub-pixel R₂ and a pixel circuit group of the pixel circuit of color sub-pixel R₃ and the pixel circuit of white sub-pixel W₁ is turned on (that is, *ϕ*_{f_1} is pulled up), and finally, signal fusion between the pixel circuit of color sub-pixel R₁, the pixel circuit of color sub-pixel R₂, the pixel circuit of color sub-pixel R₃, and the pixel circuit of white sub-pixel W₁ is implemented.

In this embodiment of this application, signal fusion processing may be performed on signals of pixel circuits of color sub-pixels, and an algorithm such as a high dynamic range is implemented in the pixel group. Signal fusion processing may be performed on the pixel circuit of white sub-pixel and the pixel circuit of color sub-pixel, so that image fusion can be completed in the pixel group, thereby avoiding chromatic aberration caused by signal attenuation when a back-end ISP performs a fusion algorithm, and reducing power consumption.

It should be noted that the control method for an image sensor provided in the embodiments of this application may be performed by a control apparatus for an image sensor, or a control module that is in the control apparatus for an image sensor and that is configured to perform the control method for an image sensor. In the embodiments of this application, that the control apparatus for an image sensor performs the control method for an image sensor is used as an example to describe the control apparatus for an image sensor provided in the embodiments of this application.

An embodiment of this application provides a control apparatus for an image sensor. The image sensor includes a pixel circuit array, the pixel circuit array includes a plurality of pixel circuit groups, each pixel circuit group includes one pixel circuit of white pixel and a plurality of pixel circuits of color pixels, the plurality of pixel circuits of color pixels are disposed around the pixel circuit of white pixel, each pixel circuit row of the pixel circuit array shares one control signal line, and each pixel circuit column of the pixel circuit array shares one output signal line. As shown in FIG. 13, the control apparatus 1300 for an image sensor includes:
a control module 1302, configured to: in a case that the pixel circuit row includes a pixel circuit of white pixel or a pixel circuit of color pixel, and the pixel circuit column includes a pixel circuit of white pixel or a pixel circuit of color pixel, based on a first fusion control signal, fuse an electrical signal generated by the pixel circuit of white pixel and an electrical signal generated by at least one pixel circuit of color pixel, to enhance an electrical signal of the pixel circuit of color pixel.

In this embodiment, signal fusion processing may be performed on the electrical signal of the pixel circuit of white pixel and electrical signals of one or more pixel circuits of color pixels. In the foregoing manner, image fusion can be completed in a pixel group, thereby avoiding chromatic aberration caused by signal attenuation when a back-end ISP performs a fusion algorithm, and reducing power consumption.

Further, in an embodiment of this application, the pixel circuit of color pixel or the pixel circuit of white pixel includes a first photosensitive element, a first switching element, and a first signal processing circuit. The control module 1302 is further configured to: control, based on a first charge transfer control signal, to turn on the first switching element, transmit an electrical signal generated by the first photosensitive element to the first signal processing circuit, and control the first signal processing circuit to perform first preset processing on the electrical signal generated by the first photosensitive element, where the first preset processing includes: setting the electrical signal generated by the first photosensitive element to an initial voltage or outputting the electrical signal generated by the first photosensitive element to the output signal line.

Further, in an embodiment of this application, the pixel circuit group includes a plurality of second switching elements, and the second switching element is connected between the pixel circuit of white pixel and the pixel circuit of color pixel. The control module 1302 is further configured to: control, based on a first fusion control signal, to turn on the second switching element, and fuse an electrical signal generated by the pixel circuit of white pixel and an electrical signal generated by the pixel circuit of color pixel, to enhance the electrical signal of the pixel circuit of color pixel.

Further, in an embodiment of this application, in a case that the pixel circuit of white pixel includes a plurality of pixel circuits of white sub-pixels and the pixel circuit of color pixel includes a plurality of pixel circuits of color sub-pixels, the pixel circuit row includes the pixel circuit of color sub-pixel or includes the pixel circuit of white sub-pixel and the pixel circuit of color sub-pixel, and the pixel circuit column includes the pixel circuit of color sub-pixel or includes the pixel circuit of white sub-pixel and the pixel circuit of color sub-pixel. The control module 1302 is further configured to control, in each pixel circuit group based on a second fusion control signal, to fuse an electrical signal generated by the pixel circuit of white sub-pixel and an electrical signal generated by the at least one pixel circuit of color sub-pixel, to enhance the electrical signal of the pixel circuit of color sub-pixel.

Further, in an embodiment of this application, the pixel circuit group includes a second signal processing circuit, and the pixel circuit of color sub-pixel or the pixel circuit of white sub-pixel includes a second photosensitive element and a third switching element. The control module 1302 is further configured to control, based on a second charge transfer control signal, to turn on the third switching element; transmit an electrical signal generated by the second photosensitive element to a second signal processing circuit; and control the second signal processing circuit to perform second preset processing on the electrical signal generated by the second photosensitive element, where the second preset processing includes: setting the electrical signal generated by the second photosensitive element to an initial voltage, or outputting the electrical signal generated by the second photosensitive element to the output signal line.

Further, in an embodiment of this application, the pixel circuit group further includes a plurality of fourth switching elements, the fourth switching element is connected between two adjacent pixel circuit teams that are in different pixel circuit columns, and the pixel circuit team includes two pixel circuits of sub-pixels that share one second signal processing circuit. The control module 1302 is further configured to: control, based on a second charge transfer control signal, to turn on the third switching element; control, based on a second fusion control signal, to turn on the fourth switching element; and fuse electrical signals generated by two pixel circuit teams corresponding to the third switching element and the fourth switching element, to enhance the electrical signals generated by the pixel circuit teams.

The control apparatus 1300 for an image sensor in this embodiment of this application may be an apparatus, or may be a component, an integrated circuit, or a chip in a terminal. The apparatus may be a mobile electronic device, or may be a non-mobile electronic device. For example, the mobile electronic device may be a mobile phone, a tablet computer, a notebook computer, a palmtop computer, an in-vehicle electronic device, a wearable device, an ultra-mobile personal computer (Ultra-Mobile Personal Computer, UMPC), a netbook, or a personal digital assistant (Personal Digital Assistant, PDA), and the non-mobile electronic device may be a server, a network attached storage (Network Attached Storage, NAS), a personal computer (Personal Computer, PC), a television (Television, TV), a teller machine, or a self-service machine. This is not specifically limited in this embodiment of this application.

The control apparatus 1300 for an image sensor in this embodiment of this application may be an apparatus with an operating system. The operating system may be an Android (Android) operating system, may be an iOS operating system, or may be another possible operating system. This is not specifically limited in this embodiment of this application.

The control apparatus 1300 for an image sensor provided in this embodiment of this application can implement the processes implemented in the method embodiment in FIG. 12. To avoid repetition, details are not described herein again.

Optionally, as shown in FIG. 14, an embodiment of this application further provides an electronic device 1400, including a processor 1402, a memory 1404, and a program or an instruction that is stored in the memory 1404 and that can run on the processor 1402. When the program or the instruction is executed by the processor 1402, processes of the embodiments of the control method for a pixel array can be implemented, and same technical effect can be achieved. To avoid repetition, details are not described herein again.

It should be noted that the electronic device in this embodiment of this application includes the foregoing mobile electronic device and the foregoing non-mobile electronic device.

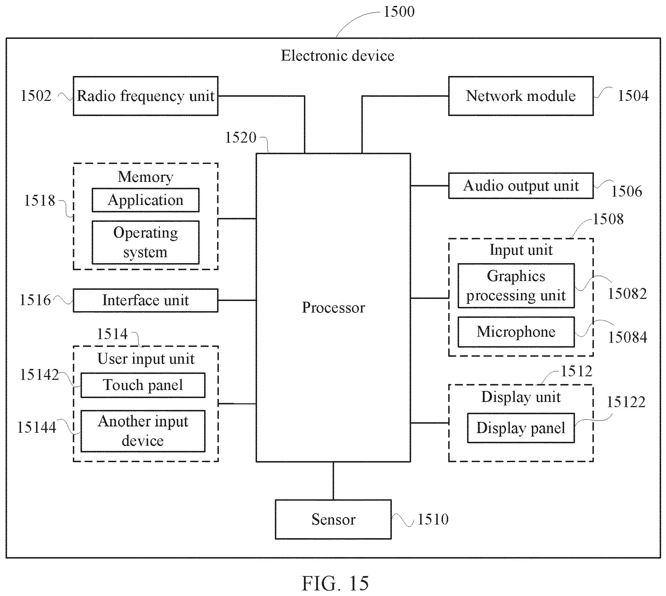

FIG. 15 is a schematic diagram of a hardware structure of an electronic device according to an embodiment of this application.

An electronic device 1500 includes but is not limited to components such as a radio frequency unit 1502, a network module 1504, an audio output unit 1506, an input unit 1508, a sensor 1510, a display unit 1512, a user input unit 1514, an interface unit 1516, a memory 1518, and a processor 1520.

A person skilled in the art can understand that the electronic device 1500 may further include a power supply (such as a battery) that supplies power to each component. The power supply may be logically connected to the processor 1520 by using a power supply management system, to implement functions such as charging and discharging management, and power consumption management by using the power supply management system. The structure of the electronic device shown in FIG. 15 does not constitute a limitation on the electronic device. The electronic device may include components more or fewer than those shown in the figure, a combination of some components, or different component arrangements. Details are not described herein again.

The sensor 1510 of the electronic device 1500 includes an image sensor. The image sensor includes a pixel circuit array, the pixel circuit array includes a plurality of pixel circuit groups, each pixel circuit group includes one pixel circuit of white pixel and a plurality of pixel circuits of color pixels, the plurality of pixel circuits of color pixels are disposed around the pixel circuit of white pixel, each pixel circuit row of the pixel circuit array shares one control signal line, and each pixel circuit column of the pixel circuit array shares one output signal line. The processor 1520 is configured to: in a case that the pixel circuit row includes a pixel circuit of white pixel or a pixel circuit of color pixel and the pixel circuit column includes a pixel circuit of white pixel or a pixel circuit of color pixel, control, in each pixel circuit group based on a first fusion control signal, to fuse an electrical signal generated by the pixel circuit of white pixel and an electrical signal generated by at least one pixel circuit of color pixel, to enhance the electrical signal of the pixel circuit of color pixel.

In this embodiment, signal fusion processing may be performed on the electrical signal of the pixel circuit of white pixel and electrical signals of one or more pixel circuits of color pixels. In the foregoing manner, image fusion can be completed in a pixel group, thereby avoiding chromatic aberration caused by signal attenuation when a back-end ISP performs a fusion algorithm, and reducing power consumption.

Further, in an embodiment of this application, the pixel circuit of color pixel or the pixel circuit of white pixel includes a first photosensitive element, a first switching element, and a first signal processing circuit. The processor 1520 is further configured to: control, based on a first charge transfer control signal, to turn on the first switching element; transmit an electrical signal generated by the first photosensitive element to a first signal processing circuit; and control the first signal processing circuit to process the electrical signal generated by the first photosensitive element.

Further, in an embodiment of this application, the pixel circuit group includes a plurality of second switching elements, and the second switching element is connected between the pixel circuit of white pixel and the pixel circuit of color pixel. The processor 1520 is further configured to control, based on a first fusion control signal, to turn on the second switching element, to fuse an electrical signal generated by the pixel circuit of white pixel and an electrical signal generated by the pixel circuit of color pixel.

Further, in an embodiment of this application, in a case that the pixel circuit of white pixel includes a plurality of pixel circuits of white sub-pixels and the pixel circuit of color pixel includes a plurality of pixel circuits of color sub-pixels, the pixel circuit row includes a pixel circuit of color sub-pixel or includes a pixel circuit of white sub-pixel and a pixel circuit of color sub-pixel, and the pixel circuit column includes a pixel circuit of color sub-pixel or includes a pixel circuit of white sub-pixel and a pixel circuit of color sub-pixel. The processor 1520 is further configured to: control, in each pixel circuit group based on a second fusion control signal, to fuse an electrical signal generated by the pixel circuit of white sub-pixel and an electrical signal generated by at least one pixel circuit of color sub-pixel, to enhance the electrical signal of the pixel circuit of color sub-pixel.

Further, in an embodiment of this application, the pixel circuit group includes a second signal processing circuit, and the pixel circuit of color sub-pixel or the pixel circuit of white sub-pixel includes a second photosensitive element and a third switching element. The processor 1520 is further configured to control, based on a second charge transfer control signal, to turn on the third switching element; transmit an electrical signal generated by the second photosensitive element to the second signal processing circuit; and control the second signal processing circuit to process the electrical signal generated by the second photosensitive element.

Further, in an embodiment of this application, the pixel circuit group further includes a plurality of fourth switching elements, the fourth switching element is connected between two adjacent pixel circuit teams in different pixel circuit columns, and the pixel circuit team includes two pixel circuits of sub-pixels that share one second signal processing circuit. The processor 1520 is further configured to: control, based on a second charge transfer control signal, to turn on the third switching element; control, based on a second fusion control signal, to turn on the fourth switching element; and fuse electrical signals generated by two pixel circuit teams corresponding to the third switching element and the fourth switching element.

It should be understood that, in this embodiment of this application, the radio frequency unit 1502 may be configured to receive and send information or a signal in a call process. Specifically, the radio frequency unit 1502 receives downlink data of a base station or sends uplink data to a base station. The radio frequency unit 1502 includes but is not limited to an antenna, at least one amplifier, a transceiver, a coupler, a low noise amplifier, a duplexer, and the like.

The network module 1504 provides wireless broadband Internet access for a user, for example, helping the user send and receive an e-mail, browse a web page, and access streaming media.

The audio output unit 1506 may convert audio data received by the radio frequency unit 1502 or the network module 1504 or stored in the memory 1518 into an audio signal and output the audio signal as sound. In addition, the audio output unit 1506 may further provide an audio output (for example, a call signal received voice, or a message received voice) related to a specific function implemented by the electronic device 1500. The audio output unit 1506 includes a speaker, a buzzer, a telephone receiver, and the like.

The input unit 1508 is configured to receive an audio signal or a video signal. The input unit 1508 may include a graphics processing unit (Graphics Processing Unit, GPU) 15082 and a microphone 15084, and the graphics processing unit 15082 processes image data of a still picture or video obtained by an image capture apparatus (such as a camera) in a video capture mode or an image capture mode. A processed image frame may be displayed on the display unit 1512, stored in the memory 1518 (or another storage medium), or sent by using the radio frequency unit 1502 or the network module 1504. The microphone 15084 may receive sound, and process the sound into audio data. Processed audio data may be converted, in a call mode, into a format that can be sent to a mobile communication base station by using the radio frequency unit 1502 for output.

The sensor 1510 may further include a fingerprint sensor, a pressure sensor, an iris sensor, a molecular sensor, a gyroscope, a barometer, a hygrometer, a thermometer, an infrared sensor, an optical sensor, a motion sensor, and another sensor.

The display unit 1512 is configured to display information entered by the user or information provided for the user. The display unit 1512 may include a display panel 15122. Optionally, the display panel 15122 may be configured in a form such as a liquid crystal display or an organic light-emitting diode.

The user input unit 1514 may be configured to: receive entered digital or character information, and generate a key signal input related to user setting and function control of the electronic device. Specifically, the user input unit 1514 includes a touch panel 15142 and another input device 15144. The touch panel 15142 is also referred to as a touchscreen, and may collect a touch operation performed by the user on or near the touch panel 5142. The touch panel 15142 may include two parts: a touch detection apparatus and a touch controller. The touch detection apparatus detects a touch location of the user, detects a signal brought by the touch operation, and transmits the signal to the touch controller. The touch controller receives touch information from the touch detection apparatus, converts the touch information into contact coordinates, sends the contact coordinates to the processor 1520, and can receive and execute a command sent by the processor 1520. The another input device 15144 may include but is not limited to a physical keyboard, a functional button (such as a volume control button or a power on/off button), a trackball, a mouse, and a joystick. Details are not described herein.

Further, the touch panel 15142 may cover the display panel 15122. When detecting the touch operation on or near the touch panel 15142, the touch panel 15142 transmits the touch operation to the processor 1520 to determine a type of a touch event, and then the processor 1520 provides a corresponding visual output on the display panel 15122 based on the type of the touch event. The touch panel 15142 and the display panel 15122 may be used as two independent components, or may be integrated into one component.

The interface unit 1516 is an interface for connecting an external apparatus to the electronic device 1500. For example, the external apparatus may include a wired or wireless headset jack, an external power supply (or a battery charger) port, a wired or wireless data port, a storage card port, a port for connecting an apparatus with an identification module, an audio input/output (I/O) port, a video I/O port, and a headset jack. The interface unit 1516 may be configured to receive an input (for example, data information and power) from an external apparatus and transmit the received input to one or more elements in the electronic device 1500, or may be configured to transmit data between the electronic device 1500 and the external apparatus.

The memory 1518 may be configured to store a software program and various data. The memory 1518 may mainly include a program storage region and a data storage region. The program storage region may store an operating system, an application required by at least one function (such as a sound playing function or an image playing function), and the like. The data storage region may store data (such as audio data or a phone book) created according to use of a mobile terminal, and the like. In addition, the memory 1518 may include a high-speed random access memory, and may further include a nonvolatile memory, for example, at least one magnetic disk storage device, a flash storage device, or another volatile solid-state storage device.

The processor 1520 is configured to implement various functions of the electronic device 1500 and data processing by running or executing the software program and/or the module stored in the memory 1518 and by invoking the data stored in the memory 1518, to perform overall monitoring on the electronic device 1500. The processor 1520 may include one or more processing units. Preferably, an application processor and a modem processor may be integrated into the processor 1520. The application processor mainly processes an operating system, a user interface, an application, and the like. The modem processor mainly processes wireless communications.

It should be noted that in this specification, the term "include", "comprise", or any other variant is intended to cover non-exclusive inclusion, so that a process, method, article, or apparatus that includes a series of elements includes not only those elements but also other elements that are not explicitly listed, or includes elements inherent to such a process, method, article, or apparatus. An element limited by "includes a ..." does not, without more constraints, preclude the presence of additional identical elements in the process, method, article, or apparatus that includes the element. In addition, it should be noted that the scope of the method and the apparatus in the embodiments of this application is not limited to performing functions in an illustrated or discussed sequence, and may further include performing functions in a basically simultaneous manner or in a reverse sequence according to the functions concerned. For example, the described method may be performed in an order different from that described, and the steps may be added, omitted, or combined. In addition, features described with reference to some examples may be combined in other examples.

Based on the descriptions of the foregoing implementations, a person skilled in the art may clearly understand that the method in the foregoing embodiment may be implemented by software in addition to a necessary universal hardware platform or by hardware only. In most circumstances, the former is a preferred implementation. Based on such an understanding, the technical solutions of this application essentially or the part contributing to the prior art may be implemented in a form of a software product. The computer software product is stored in a storage medium (such as a ROM/RAM, a hard disk, or an optical disc), and includes several instructions for instructing a terminal (which may be a mobile phone, a computer, a server, an air conditioner, a network device, or the like) to perform the methods described in the embodiments of this application.

The embodiments of this application are described above with reference to the accompanying drawings, but this application is not limited to the above specific implementations, and the above specific implementations are only illustrative and not restrictive. Under the enlightenment of this application, those of ordinary skill in the art can make many forms without departing from the purpose of this application and the protection scope of the claims, all of which fall within the protection of this application.

## Claims

1. An image sensor, comprising:
a pixel circuit array, wherein the pixel circuit array comprises a plurality of pixel circuit groups, each pixel circuit group comprises one pixel circuit of white pixel and a plurality of pixel circuits of color pixels, and the plurality of pixel circuits of color pixels are disposed around the pixel circuit of white pixel; wherein
each pixel circuit row of the pixel circuit array shares one control signal line, and each pixel circuit column of the pixel circuit array shares one output signal line; and
the pixel circuit array comprises at least two pixel circuit rows and at least two pixel circuit columns, the pixel circuit row comprises the pixel circuit of white pixel or the pixel circuit of color pixel, and the pixel circuit column comprises the pixel circuit of white pixel or the pixel circuit of color pixel.

2. The image sensor according to claim 1, wherein a pixel circuit comprises:
a first photosensitive element;
a first switching element, connected to the first photosensitive element; and
a first signal processing circuit, connected to the first switching element and the output signal line; wherein
the pixel circuit comprises the pixel circuit of color pixel or the pixel circuit of white pixel.

3. The image sensor according to claim 1, wherein the pixel circuit group further comprises:
a plurality of second switching elements, wherein the second switching element is connected between the pixel circuit of white pixel and the pixel circuit of color pixel.

4. The image sensor according to any one of claims 1 to 3, wherein
in a case that the pixel circuit of white pixel comprises a plurality of pixel circuits of white sub-pixels, and the pixel circuit of color pixel comprises a plurality of pixel circuits of color sub-pixels,
the pixel circuit row comprises the pixel circuit of color sub-pixel or comprises the pixel circuit of white sub-pixel and the pixel circuit of color sub-pixel; and
the pixel circuit column comprises the pixel circuit of color sub-pixel or comprises the pixel circuit of white sub-pixel and the pixel circuit of color sub-pixel.

5. The image sensor according to claim 4, wherein the pixel circuit group further comprises:
a second signal processing circuit, connected to the output signal line; and the pixel circuit comprises:
a second photosensitive element; and
a third switching element, connected to the second photosensitive element and the second signal processing circuit; wherein
the pixel circuit comprises the pixel circuit of color pixel or the pixel circuit of white pixel.

6. The image sensor according to claim 5, wherein
two adjacent pixel circuits of sub-pixels in each column of pixel circuits of sub-pixels of the pixel circuit array share one second signal processing circuit; and
the second signal processing circuit is connected to two adjacent third switching elements.

7. The image sensor according to claim 6, wherein the pixel circuit group further comprises:
a plurality of fourth switching elements, wherein the fourth switching element is connected between two adjacent pixel circuit teams in different pixel circuit columns, and the pixel circuit team comprises two pixel circuits of sub-pixels that share one second signal processing circuit.

8. An electronic device, comprising:
the image sensor according to any one of claims 1 to 7.

9. A control method for an image sensor, wherein the image sensor comprises a pixel circuit array, the pixel circuit array comprises a plurality of pixel circuit groups, each pixel circuit group comprises one pixel circuit of white pixel and a plurality of pixel circuits of color pixels, the plurality of pixel circuits of color pixels are disposed around the pixel circuit of white pixel, each pixel circuit row of the pixel circuit array shares one control signal line, and each pixel circuit column of the pixel circuit array shares one output signal line; and
the control method comprises:
in a case that the pixel circuit row comprises the pixel circuit of white pixel or the pixel circuit of color pixel, and the pixel circuit column comprises the pixel circuit of white pixel or the pixel circuit of color pixel, based on a first fusion control signal, fusing an electrical signal generated by the pixel circuit of white pixel and an electrical signal generated by at least one pixel circuit of color pixel, to enhance the electrical signal of the pixel circuit of color pixel.

10. The control method according to claim 9, wherein the pixel circuit of color pixel or the pixel circuit of white pixel comprises a first photosensitive element, a first switching element, and a first signal processing circuit; and
the control method comprises:
controlling, based on a first charge transfer control signal, to turn on the first switching element, and transmitting an electrical signal generated by the first photosensitive element to the first signal processing circuit; and
controlling the first signal processing circuit to perform first preset processing on the electrical signal generated by the first photosensitive element; wherein
the first preset processing comprises: setting the electrical signal generated by the first photosensitive element to an initial voltage, or outputting the electrical signal generated by the first photosensitive element to the output signal line.

11. The control method according to claim 9, wherein the pixel circuit group comprises a plurality of second switching elements, and the second switching element is connected between the pixel circuit of white pixel and the pixel circuit of color pixel; and
the control method comprises:
controlling, based on the first fusion control signal, to turn on the second switching element, and fusing an electrical signal generated by the pixel circuit of white pixel and an electrical signal generated by the pixel circuit of color pixel, to enhance the electrical signal of the pixel circuit of color pixel.

12. The control method according to any one of claims 9 to 11, wherein in a case that the pixel circuit of white pixel comprises a plurality of pixel circuits of white sub-pixels and the pixel circuit of color pixel comprises a plurality of pixel circuits of color sub-pixels, the pixel circuit row comprises the pixel circuit of color sub-pixel or comprises the pixel circuit of white sub-pixel and the pixel circuit of color sub-pixel, and the pixel circuit column comprises the pixel circuit of color sub-pixel or comprises the pixel circuit of white sub-pixel and the pixel circuit of color sub-pixel; and
the control method further comprises: controlling, in each pixel circuit group based on a second fusion control signal, to fuse an electrical signal generated by the pixel circuit of white sub-pixel and an electrical signal generated by at least one pixel circuit of color sub-pixels, to enhance the electrical signal of the pixel circuit of color sub-pixel.

13. The control method according to claim 12, wherein the pixel circuit group comprises a second signal processing circuit, and the pixel circuit of color sub-pixel or the pixel circuit of white sub-pixel comprises a second photosensitive element and a third switching element; and
the control method comprises:
controlling, based on a second charge transfer control signal, to turn on the third switching element, and transmitting an electrical signal generated by the second photosensitive element to the second signal processing circuit; and
controlling the second signal processing circuit to perform second preset processing on the electrical signal generated by the second photosensitive element; wherein
the second preset processing comprises: setting the electrical signal generated by the second photosensitive element to an initial voltage, or outputting the electrical signal generated by the second photosensitive element to the output signal line.

14. The control method according to claim 13, wherein the pixel circuit group further comprises a plurality of fourth switching elements, the fourth switching element is connected between two adjacent pixel circuit teams in different pixel circuit columns, and the pixel circuit team comprises two pixel circuits of sub-pixels that share one second signal processing circuit; and
the control method further comprises:
controlling, based on the second charge transfer control signal, to turn on the third switching element; controlling, based on the second fusion control signal, to turn on the fourth switching element; and fusing electrical signals generated by two pixel circuit teams corresponding to the third switching element and the fourth switching element, to enhance the electrical signals generated by the pixel circuit teams.

15. A control apparatus for an image sensor, wherein the image sensor comprises a pixel circuit array, the pixel circuit array comprises a plurality of pixel circuit groups, each pixel circuit group comprises one pixel circuit of white pixel and a plurality of pixel circuits of color pixels, the plurality of pixel circuits of color pixels are disposed around the pixel circuit of white pixel, each pixel circuit row of the pixel circuit array shares one control signal line, and each pixel circuit column of the pixel circuit array shares one output signal line; and
the control apparatus comprises:
a control module, configured to: in a case that the pixel circuit row comprises the pixel circuit of white pixel or the pixel circuit of color pixel, and the pixel circuit column comprises the pixel circuit of white pixel or the pixel circuit of color pixel, based on a first fusion control signal, fuse an electrical signal generated by the pixel circuit of white pixel and an electrical signal generated by at least one pixel circuit of color pixel, to enhance the electrical signal of the pixel circuit of color pixel.

16. The control apparatus according to claim 15, wherein the pixel circuit of color pixel or the pixel circuit of white pixel comprises a first photosensitive element, a first switching element, and a first signal processing circuit; and
the control module is further configured to: control, based on a first charge transfer control signal, to turn on the first switching element, transmit an electrical signal generated by the first photosensitive element to the first signal processing circuit; and control the first signal processing circuit to perform first preset processing on the electrical signal generated by the first photosensitive element, wherein the first preset processing comprises: setting the electrical signal generated by the first photosensitive element to an initial voltage, or outputting the electrical signal generated by the first photosensitive element to the output signal line.

17. The control apparatus according to claim 15, wherein the pixel circuit group comprises a plurality of second switching elements, and the second switching element is connected between the pixel circuit of white pixel and the pixel circuit of color pixel; and
the control module is further configured to: control, based on a first fusion control signal, to turn on the second switching element, and fuse an electrical signal generated by the pixel circuit of white pixel and an electrical signal generated by the pixel circuit of color pixel, to enhance the electrical signal of the pixel circuit of color pixel.

18. The control apparatus according to any one of claims 15 to 17, wherein in a case that the pixel circuit of white pixel comprises a plurality of pixel circuits of white sub-pixels and the pixel circuit of color pixel comprises a plurality of pixel circuits of color sub-pixels, the pixel circuit row comprises the pixel circuit of color sub-pixel or comprises the pixel circuit of white sub-pixel and the pixel circuit of color sub-pixel, and the pixel circuit column comprises the pixel circuit of color sub-pixel or comprises the pixel circuit of white sub-pixel and the pixel circuit of color sub-pixel; and
the control module is further configured to control, in each pixel circuit group based on a second fusion control signal, to fuse an electrical signal generated by the pixel circuit of white sub-pixel and an electrical signal generated by the at least one pixel circuit of color sub-pixel, to enhance the electrical signal of the pixel circuit of color sub-pixel.

19. An electronic device, comprising a processor, a memory, and a program or an instruction that is stored in the memory and that can be run on the processor, wherein when the program or the instruction is executed by the processor, steps of the control method for an image sensor according to any one of claims 9 to 14 are implemented.

20. A readable storage medium, wherein the readable storage medium stores a program or an instruction, and when the program or the instruction is executed by a processor, steps of the control method for an image sensor according to any one of claims 9 to 14 are implemented.
